# EUROPÄISCHE PATENTSCHRIFT

(11) **EP 4 174 235 B1**
(45) Veröffentlichungstag und Bekanntmachung des Hinweises auf die Patenterteilung: **17.09.2025**
(21) Anmeldenummer: 22203541.2
(22) Anmeldetag: 25.10.2022
(51) Int. Cl.: E02F 9/08, E01C 19/34

(54) **ELEKTRISCHE ARBEITSMASCHINE MIT AKKUKÜHLUNG**
ELECTRIC WORKING MACHINE WITH BATTERY COOLING
MACHINE DE TRAVAIL ÉLECTRIQUE AVEC REFROIDISSEMENT DE BATTERIE

(30) Priorität: 29.10.2021 DE 102021128350
(43) Veröffentlichungstag der Anmeldung: 03.05.2023
(73) Patentinhaber: Wacker Neuson Produktion GmbH & Co. KG, 85084 Reichertshofen (DE)
(72) Erfinder: GALLE, Steffen, 84034 Landshut (DE); BACHMANN, Matthias, 86633 Neuburg (DE); WEISKOPF, Alto, 85250 Altomünster (DE)
(74) Vertreter: Müller Hoffmann & Partner

(56) Entgegenhaltungen:
- EP-A1- 2 584 100
- EP-A1- 2 857 587
- DE-A1- 102009 004 443
- DE-A1- 102011 115 008

## Beschreibung

Die Erfindung betrifft eine Arbeitsmaschine, insbesondere eine akkubetriebene Baumaschine mit Elektroantrieb.

Akkubetriebene Baumaschinen weisen einen Antriebsstrang auf, mit einem Elektromotor, einem Energiespeicher (Akku) und einem Umformer. Der Umformer wandelt den Strom aus dem Energiespeicher (üblicherweise ein Gleichstrom) in einen zum Versorgen des Elektromotors geeigneten Strom, z.B. einen Wechselstrom. Die Komponenten müssen effizient gekühlt werden, damit die Baumaschine zuverlässig arbeiten kann. Dies gilt vor allem für den Akku, dessen Zellen bei übermäßiger Wärmeeinwirkung dauerhaften Schaden nehmen können, was nicht nur die Speicherkapazität, sondern auch die Lebensdauer des Akkus vermindern kann.

Zur Kühlung von Akku und Umformer ist es bekannt, an dem als Antriebsmotor dienenden Elektromotor der Baumaschine ein Lüfterrad vorzusehen, das einen Luftstrom erzeugt. Der Luftstrom kann dann nicht nur über den Antriebsmotor, sondern auch über den Akku und den Umformer geführt werden, um eine geeignete Kühlung beim Betrieb der Baumaschine zu bewirken.

Je nach Typ der Baumaschine ist es möglich, dass der Akku und der Umformer mit einiger Entfernung zum Elektromotor angeordnet sind. Für diesen Fall ist es notwendig, dass der Kühlluftstrom über Kühlkanäle (Luftführungskanäle) geleitet wird, damit der am Antriebsmotor durch den dort vorhandenen Lüfter erzeugte Kühlluftstrom auch auf Akku und Umformer wirkt. Je nach Länge und Gestaltung der Luftführungskanäle kann die Kühlwirkung am Akku und am Umformer nur gering sein.

Die Kühlwirkung wird nur während des Betriebs des Antriebsmotors erreicht, weil auch nur dann das Lüfterrad angetrieben wird. In anderen Betriebssituationen besteht daher das Risiko einer zu starken Wärmeeinwirkung auf Akku oder Umformer, wenn der Antriebsmotor nicht im Betrieb ist und damit kein Kühlluftstrom erzeugt wird.

Aus EP 2 857 587 A1 ist eine Bodenverdichtungsvorrichtung mit luftgekühltem Akku bekannt. Dabei ist der Akku an einem Führungshandgriff der Bodenverdichtungsvorrichtung befestigt. Es ist eine Luftfördervorrichtung zum Erzeugen eines Kühlluftstroms für den Akku vorgesehen. Die Luftfördervorrichtung wird durch einen Antriebsmotor der Bodenverdichtungsvorrichtung angetrieben.

Der Erfindung liegt die Aufgabe zugrunde, eine Arbeitsmaschine anzugeben, mit einer verbesserten Kühlung für Akku und Umformer.

Die Aufgabe wird durch eine Arbeitsmaschine mit den Merkmalen von Anspruch 1 gelöst. Vorteilhafte Ausgestaltungen sind in den abhängigen Ansprüchen angegeben.

Es wird eine Arbeitsmaschine angegeben, mit einer Arbeitsvorrichtung zum Bewirken einer Arbeitsbewegung und mit einem Antrieb zum Antreiben der Arbeitsvorrichtung, wobei der Antrieb einen elektrischen Arbeitsmotor, einen elektrischen Energiespeicher zum Versorgen des Antriebsmotors mit elektrischem Strom und eine Umformereinrichtung zum Umformen des Stroms aus dem Energiespeicher und Zuführen des Stroms zu dem Antriebsmotor aufweist. Dabei ist eine Kühlvorrichtung vorgesehen, zum Kühlen des Energiespeichers und der Umformereinrichtung, wobei die Kühlvorrichtung wenigstens eine Lüftereinrichtung aufweist, zum Erzeugen eines Kühlluftstroms, der über den Energiespeicher und die Umformereinrichtung führbar ist, wobei die Lüftereinrichtung einen Lüfter und einen den Lüfter antreibenden Lüftermotor aufweist, und wobei der Lüftermotor getrennt von dem Antriebsmotor des Antriebs vorgesehen ist.

Bei der Arbeitsmaschine kann es sich z.B. um einen Vibrationsstampfer (Rüttelstampfer) oder um eine Vibrationsplatte (Rüttelplatte) zur Bodenverdichtung handeln. Dementsprechend kann die Arbeitsbewegung eine Stampfbewegung oder Rüttelbewegung sein, die in an sich bekannter, geeigneter Weise z.B. in den Boden eingelassen wird. Auch andere Baumaschinen können als derartige Arbeitsmaschinen eingesetzt werden.

Bei dem Energiespeicher kann es sich um einen Akku bzw. eine wiederaufladbare Batterie mit an sich bekannter Bauart handeln.

Die Umformereinrichtung kann z.B. ein Frequenzumformer sein, der geeignet ist, um die Spannung und Frequenz des aus dem Energiespeicher zugeführten Stroms umzuformen, zu einem Strom, der für den Betrieb des elektrischen Antriebsmotors (Elektromotors) geeignet ist.

Der Lüfter kann als Ventilator oder Propeller oder andere Einrichtung ausgebildet sein, die durch den Lüftermotor angetrieben wird, um den gewünschten Kühlluftstrom zu erzeugen.

Der Lüftermotor selbst kann ebenfalls ein Elektromotor sein. Er ist zusätzlich zum Antriebsmotor vorgesehen und kann in der Nähe oder auch entfernt vom Antriebsmotor an der Arbeitsmaschine angeordnet sein.

Zur Führung des Kühlluftstroms können geeignete Luftführungskanäle wie Schläuche, Rohre oder auch geeignet gestaltete Gehäuseelemente vorgesehen sein.

Dabei ist es wichtig, dass der Kühlluftstrom über den Energiespeicher und die Umformereinrichtung geführt werden kann. Insbesondere sollte der Kühlluftstrom entlang der Außenwände von Energiespeicher und Umformereinrichtung, also entlang dem Gehäuse geführt werden. Ebenso ist es aber auch möglich, dass der Kühlluftstrom durch die jeweiligen Gehäuse geführt wird, um die Wärme enthaltenden Komponenten bestmöglich zu erreichen, damit eine wirksame Kühlung erzielt werden kann.

Es ist möglich, mehrere Lüftereinrichtungen mit mehreren Lüftern und/oder Lüftermotoren vorzusehen, um ein flexibles Kühlkonzept vorzusehen. Die Kühlvorrichtung kann über die dann die mehreren Lüfter in geeigneter Weise verfügen und die Lüfter z.B. auch individuell ansteuern.

Eine elektrische Versorgung des Lüftermotors bzw. der gegebenenfalls mehreren Lüftermotoren kann mit Hilfe der Energie aus dem elektrischen Energiespeicher erfolgen.

Je nach Gestaltung der Arbeitsmaschine ist es möglich, dass für den eigentlichen Antriebsmotor keine Kühlung vorgesehen ist, sondern dass die Kühlung allein für die Komponenten Energiespeicher und Umformereinrichtung erfolgt. Die Kühlung des Antriebsmotors kann dann immanent durch Konvektion oder Strahlung möglich sein.

Der Kühlluftstrom kann zwischen dem Energiespeicher und der Umformereinrichtung geführt sein. Dabei ist es möglich, den Kühlluftstrom - je nach Gestaltung - in beide Richtungen zu führen, also entweder zunächst über den Energiespeicher und dann stromab vom Energiespeicher über die Umformereinrichtung oder in umgekehrter Richtung. Da der Energiespeicher die häufig sehr wärmesensitiven Zellen der Batterie umfasst, kann es zweckmäßig sein, die aus der Umgebung angesaugte Kühlluft zunächst über den Energiespeicher und erst danach, wenn sie schon die Wärme des Energiespeichers aufgenommen hat, über den Umformer zu führen.

Der Lüfter kann im Kühlluftstrom zwischen dem Energiespeicher und der Umformereinrichtung angeordnet sein. Der Lüfter dient zum Erzeugen des Kühlluftstroms und bewirkt je nach Strömungsrichtung einen Saugeffekt oder einen Gebläseeffekt (Drücken der Kühlluft in Stromab-Richtung). Die Anordnung des Lüfters zwischen Energiespeicher und Umformereinrichtung ermöglicht einen besonders kompakten Aufbau. Gleichzeitig ist es möglich, den Lüfter relativ klein auszuführen, weil beide Strömungsseiten (stromauf und stromab vom Lüfter) genutzt werden, um den Kühlluftstrom zu erzeugen und die jeweils dort angeordnete Komponente zu kühlen.

Es kann eine Lüftungssteuerungseinrichtung vorgesehen sein, um Ansteuern des Lüftermotors. Die Lüftungssteuerungseinrichtung kann den Lüftermotor insbesondere unabhängig vom eigentlichen Antriebsmotor der Arbeitsmaschine ansteuern. Insbesondere erlaubt die Steuerung ein temperaturabhängiges Ein- und Ausschalten des Lüftermotors und somit kein betriebsabhängiges Schalten des Lüftermotors in Abhängigkeit vom Ein- und Ausschalten des Antriebsmotors.

Als maßgebliche Temperatur kann die Lüftungssteuerungseinrichtung z.B. die Temperatur in der Umgebung, am bzw. im Umformer und/oder am oder im Energiespeicher berücksichtigen. Auch ist es möglich, die Lüfterdrehzahl in Abhängigkeit von der Temperatur zu regeln, um einen unnötig starken Betrieb der Kühlvorrichtung und damit auch einen unnötigen Energieverbrauch zu vermeiden.

Auf diese Weise kann eine bedarfsgerechte Kühlung des Energiespeichers und der Umformereinrichtung erreicht werden. Dadurch lässt sich eine frühzeitige Zellalterung in dem Energiespeicher vermeiden, wodurch die Energie- und Leistungskapazität der Zellen gesteigert werden kann.

Die erforderliche Stromversorgung der Lüftungssteuerungseinrichtung wie auch der Lüftereinrichtung kann ebenfalls über den Energiespeicher und gegebenenfalls auch über die Umformereinrichtung bereitgestellt werden.

Bei einer Ausführungsform der Arbeitsmaschine können eine Obermasse und eine Untermasse vorgesehen sein, wobei die Untermasse relativ zu der Obermasse bewegbar ist, wobei an der Obermasse der Energiespeicher, die Umformereinrichtung und die Kühlvorrichtung angeordnet sind, und wobei an der Untermasse eine Bodenkontaktplatte vorgesehen sein kann, zum Ausführen der Arbeitsbewegung.

Diese Arbeitsmaschine kann z.B. als Stampfer oder Rüttelplatte bzw. Vibrationsplatte ausgeführt sein. Dementsprechend kann die Arbeitsvorrichtung zwischen Obermasse und Untermasse wirken und z.B. als Stampfvorrichtung oder als Schwingungserreger ausgebildet sein. Zwischen Obermasse und Untermasse kann eine Federeinrichtung bzw. eine Feder-Dämpfereinrichtung vorgesehen sein, um eine Schwingungsentkopplung zwischen Obermasse und Untermasse zu erreichen und die Relativbeweglichkeit zu ermöglichen.

Der Antriebsmotor kann je nach Ausführungsform an der Obermasse oder an der Untermasse angeordnet sein. Bei einem Stampfer wird es sinnvoll sein, den Antriebsmotor an der Obermasse anzuordnen und die Antriebsbewegung des Antriebsmotors über eine als Arbeitsvorrichtung dienende Stampfvorrichtung auf die Untermasse mit der Bodenkontaktplatte zu übertragen.

Dieses Prinzip ist auch bei einer Vibrationsplatte realisierbar, bei der die Antriebsbewegung des Antriebsmotors an der Obermasse dann auf den Schwingungserreger an der Untermasse übertragen werden muss.

Bei einer Variante kann der Antriebsmotor auch direkt an der Untermasse, z.B. direkt auf der Bodenkontaktplatte angebracht sein und dort mit einem Schwingungserreger gekoppelt werden.

Die Obermasse kann eine Griffeinrichtung aufweisen, zum Führen der Arbeitsmaschine durch einen Benutzer, wobei der Energiespeicher und die Lüftereinrichtung an der Griffeinrichtung angeordnet sein können. Bei dieser Ausführungsform kann die Arbeitsmaschine z.B. als Stampfer ausgebildet sein. Die Griffeinrichtung, z.B. ein an sich bekannter Griffbügel, kann vom Rest der Obermasse durch eine Schwingungsentkopplungseinrichtung entkoppelt sein, um den die Griffeinrichtung greifenden Benutzer vor starken Schwingungen zu schützen, so dass die auf den Benutzer einwirkenden Hand-Arm-Vibrationen unterhalb von zulässigen Grenzwerten bleiben.

Der Energiespeicher und die Lüftereinrichtung können an der Griffeinrichtung angebracht sein bzw. von der Griffeinrichtung getragen werden. Da die Griffeinrichtung, wie oben dargelegt, schwingungsentkoppelt sein kann, werden dann auch der Energiespeicher und die Lüftereinrichtung nur geringen Schwingungen ausgesetzt, was ihre Lebensdauer erhöht bzw. keine weiteren Schwingungsentkopplungsmaßnahmen erfordert. Umgekehrt trägt die durch den Energiespeicher und den Lüfter bewirkte höhere Masse an der Griffeinrichtung auch zu einer besseren Schwingungsreduzierung am Griffbügel bei.

Die Umformereinrichtung kann an der Griffeinrichtung angeordnet sein. Das bedeutet, dass der Umformer zusätzlich zum Energiespeicher und zum Lüfter ebenfalls von dem Griffbügel getragen werden kann.

An der Griffeinrichtung kann eine Abdeckung vorgesehen sein, wobei der Energiespeicher und/oder die Lüftereinrichtung und/oder die Umformereinrichtung unter der Abdeckung angeordnet sein können. Die Abdeckung dient als Schutz, insbesondere für den Energiespeicher und den Umformer. Zudem können in der Abdeckung geeignete Luftführungskanäle ausgebildet sein, um die von der Lüftereinrichtung geförderte Kühlluft zu den zu kühlenden Komponenten zu führen.

Die Arbeitsmaschine kann eine Bodenverdichtungsvorrichtung sein. Insbesondere kann die Arbeitsmaschine eine Stampfvorrichtung oder eine Vibrationsplatte zur Bodenverdichtung sein.

Mithilfe der Erfindung ist es möglich, das Thermomanagement bei einer Arbeitsmaschine zu verbessern, um ein Überhitzen des Akkus und auch des Umformers zu vermeiden und somit für eine Schonung und eine Verlängerung der Lebensdauer des Akkus zu sorgen.

Durch die Nutzung von Lüftern, z.B. montiert am Griffbügel vor oder unterhalb des Umformers, kann der kühlende Luftstrom zunächst über den Akku angesaugt und danach über den Umformer geführt werden. Die Ansteuerung des Lüfters unabhängig vom Betriebszustand des Antriebsmotors kann den Einsatz auch in warmen Umgebungen, z.B. bei starker Sonneneinstrahlung, ermöglichen.

Diese und weitere Vorteile und Merkmale der Erfindung werden nachfolgend anhand von Beispielen unter Zuhilfenahme der begleitenden Figuren näher erläutert. Es zeigen:
- **Fig. 1**: in schematischer seitlicher Schnittdarstellung eine erfindungsgemäße Arbeitsmaschine als Rüttelstampfer; und
- **Fig. 2**: in schematischer Seitenansicht eine andere erfindungsgemäße Arbeitsmaschine als Vibrationsplatte.

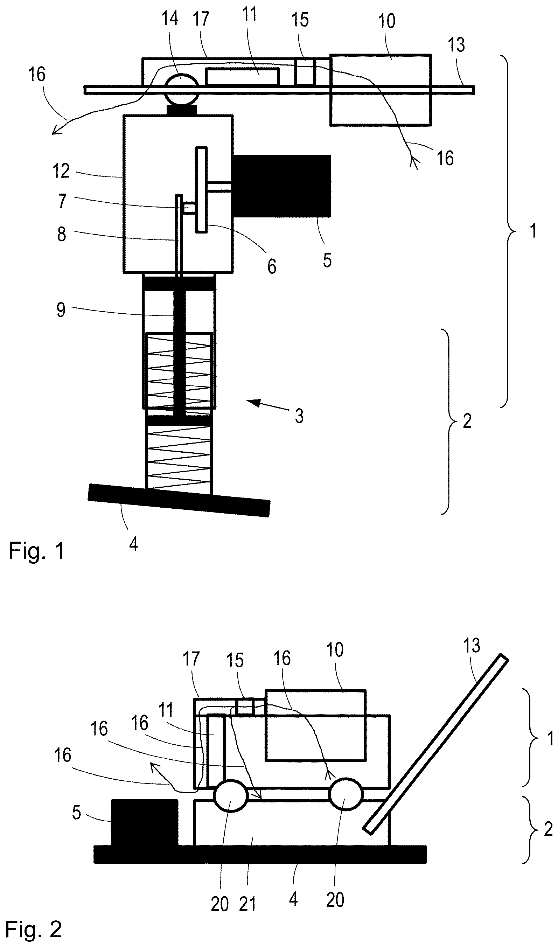

Fig. 1 zeigt schematisch einen Rüttel- bzw. Vibrationsstampfer, mit einer Obermasse 1 und einer relativ zu der Obermasse 1 bewegliche Untermasse 2. Die Obermasse 1 und die Untermasse 2 sind durch eine an sich bekannte Federeinrichtung 3 miteinander gekoppelt. An der Unterseite der Untermasse 2 ist eine Bodenkontaktplatte 4 zur Bodenverdichtung vorgesehen.

An der Obermasse 1 ist ein Antrieb mit einem Elektromotor 5 vorgesehen, der ein Kurbelrad 6 drehend antreibt, das über einen Kurbelzapfen 7 mit einem Pleuel 8 gekoppelt ist. Das Pleuel 8 ist mit einem Stampfkolben 9 verbunden, so dass die Drehbewegung des Kurbelrads 6 in eine Hin- und Herbewegung des Stampfkolbens 9 gewandelt wird. Die lineare Bewegung des Stampfkolbens 9 wird dann schließlich über die Federeinrichtung 3 auf die Bodenkontaktplatte 4 übertragen, die die eigentliche Stampfbewegung ausführt.

Zur Energieversorgung des Elektromotors 5 ist ein als elektrischer Energiespeicher dienender Akku 10 vorgesehen.

Der vom Akku 10 bereitgestellte elektrische Strom wird von einem als Umformereinrichtung dienenden Umformer 11 hinsichtlich seiner Spannung und seiner Frequenz in einem für den Elektromotor 5 geeignete Strom gewandelt bzw. umgeformt. Insbesondere kann es dabei möglich sein, aus dem im Akku 10 gespeicherten Gleichstrom einen Wechselstrom für den Elektromotor 5 zu erzeugen.

Das Kurbelrad 6, der Kurbelzapfen 7 und das Pleuel 8 sind in einem Kurbelgehäuse 12 untergebracht, an dem auch der Elektromotor 5 befestigt ist. Bei einer Variante kann der Elektromotor 5 auch weitgehend im Inneren des Kurbelgehäuses 12 angeordnet sein.

An der Oberseite des Kurbelgehäuses 12 ist eine zu der Obermasse 1 gehörende, als Griffbügel ausgebildete Griffeinrichtung 13 angebracht. Zur Schwingungsentkopplung der Griffeinrichtung 13 ist zwischen der Griffeinrichtung 13 und dem Kurbelgehäuse 12 eine Schwingungsentkopplungseinrichtung 14, z.B. in Form von Gummipuffern, angeordnet. Dadurch ist die Griffeinrichtung 13 in gewissen Grenzen relativ zu der restlichen Obermasse 1, insbesondere relativ zum Kurbelgehäuse 12 verschwenkbar, um einen Bediener, der den Griffbügel bzw. die Griffeinrichtung 13 bestimmungsgemäß am in Fig. 1 rechten Ende greift, vor der Einwirkung übermäßig starker Schwingungen zu schützen.

Sowohl der Akku 10 als auch der Umformer 11 sind an der Griffeinrichtung 13 befestigt bzw. werden von dieser getragen. Dabei ist es möglich, dass der Akku 10 wechselbar an der Griffeinrichtung 13 befestigt ist, so dass er jeweils durch einen frischen Akku 10 ersetzt werden kann.

Räumlich zwischen dem Akku 10 und dem Umformer 11 ist eine Lüftereinrichtung 15 angeordnet, die einen Lüfter, z.B. einen Ventilator, und einen Lüftermotor aufweist.

Die Lüftereinrichtung 15 erzeugt einen Kühlluftstrom 16, in dem sie Luft über den Akku 10 einsaugt und stromab über den Umformer 11 drückt, bis der Kühlluftstrom 16 wieder in die Umgebung gelangt. Der Verlauf des Kühlluftstroms 16 ist in Fig. 1 symbolhaft durch einen Pfeil dargestellt.

Zur besseren Führung des Kühlluftstroms 16 sowie zum Schutz der verschiedenen Komponenten ist eine Abdeckung 17, z.B. eine Kunststoffhaube, vorgesehen.

Bei einer nicht dargestellten Variante kann die Lüftereinrichtung 15 auch stromauf von dem Akku 10 oder stromab von dem Umformer 11 angeordnet sein, um den Kühlluftstrom 16 (vgl. Pfeilrichtung) in geeigneter Weise zu erzeugen.

Fig. 2 zeigt eine andere Ausführungsform der Arbeitsmaschine als Vibrationsplatte. Funktional ähnliche oder identische Komponenten wie bei der Ausführungsform von Fig. 1 werden mit gleichen Bezugszeichen bezeichnet.

Demgemäß weist die Vibrationsplatte ebenfalls eine Obermasse 1 und eine Untermasse 2 auf, wobei die Untermasse 2 relativ zu der Obermasse 1 beweglich ist. Dazu sind Schwingungsentkopplungselemente 20 zwischen der Obermasse 1 und der Untermasse 2 vorgesehen.

An der Untermasse 2 ist eine Bodenkontaktplatte 4 ausgebildet. Auf der Bodenkontaktplatte 4 ist der Elektromotor 5 angeordnet, der einen Schwingungserreger 21 antreibt. Der Schwingungserreger 21 kann z.B. eine oder mehrere Unwuchtwellen aufweisen, die durch den als Antriebsmotor dienenden Elektromotor 5 in Rotation versetzt werden, um die gewünschten Schwingungen zu erzeugen. Die Schwingungen werden dann über die Bodenkontaktplatte 4 direkt in den zu verdichtenden Boden eingeleitet.

Der die Energie für den Elektromotor 5 bereitstellende Akku 10 ist an der Obermasse 1 angeordnet, zusammen mit dem Umformer 11.

Wie bei der Ausführungsform von Fig. 1 ist zwischen dem Akku 10 und dem Umformer 11 die Lüftereinrichtung 15 angeordnet, um den Kühlluftstrom 16 durch den Akku 10 und entlang dem Umformer 11 zu bewirken. Wie erkennbar, kann der Kühlluftstrom 16 stromab von der Lüftereinrichtung 15 derart geführt, dass der Umformer 11 möglichst allseitig bzw. wenigstens beidseitig von Kühlluftstrom 16 umströmt wird. Je nach Ausgestaltung genügt aber auch die Kühlwirkung, wenn der Akku 10 und/oder Umformer 11 nur einseitig beströmt werden.

Zur verbesserten Führung des Kühlluftstroms 16 ist die Abdeckung 17 vorgesehen.

Die Griffeinrichtung 13 ist bei der Vibrationsplatte in Form einer durch einen Bediener führbaren Deichsel ausgebildet, die an der Untermasse 2 befestigt ist.

## Patentansprüche

1. Arbeitsmaschine, mit
- einer Arbeitsvorrichtung zum Bewirken einer Arbeitsbewegung; und mit
- einem Antrieb zum Antreiben der Arbeitsvorrichtung;
wobei
- der Antrieb einen elektrischen Antriebsmotor (5), einen elektrischen Energiespeicher (10) zum Versorgen des Antriebsmotors (5) mit elektrischem Strom und eine Umformereinrichtung (11) zum Umformen des Stroms aus dem Energiespeicher (10) und Zuführen des Stroms zu dem Antriebsmotor (5) aufweist;
- eine Kühlvorrichtung vorgesehen ist, zum Kühlen des Energiespeichers (10) und der Umformereinrichtung (11);
- die Kühlvorrichtung wenigstens eine Lüftereinrichtung (15) aufweist, zum Erzeugen eines Kühlluftstroms (16), der über den Energiespeicher (10) und die Umformereinrichtung (11) führbar ist;
- die Lüftereinrichtung (15) einen Lüfter und einen den Lüfter antreibenden Lüftermotor aufweist; **dadurch gekennzeichnet, dass**
- der Lüftermotor getrennt von dem Antriebsmotor (5) des Antriebs vorgesehen ist; und wobei
- der Lüfter im Kühlluftstrom (16) zwischen dem Energiespeicher (10) und der Umformereinrichtung (11) angeordnet ist.

2. Arbeitsmaschine nach Anspruch 1, wobei der Kühlluftstrom (16) zwischen dem Energiespeicher (10) und der Umformereinrichtung (11) geführt ist.

3. Arbeitsmaschine nach einem der vorstehenden Ansprüche, wobei eine Lüftungssteuerungseinrichtung vorgesehen ist, zum Ansteuern des Lüftermotors.

4. Arbeitsmaschine nach einem der vorstehenden Ansprüche, wobei
- eine Obermasse (1) und eine Untermasse (2) vorgesehen sind;
- die Untermasse (2) relativ zu der Obermasse (1) bewegbar ist;
- an der Obermasse (1) der Energiespeicher (10), die Umformereinrichtung (11) und die Kühlvorrichtung angeordnet sind; und wobei
- an der Untermasse (2) eine Bodenkontaktplatte (4) vorgesehen ist, zum Ausführen der Arbeitsbewegung.

5. Arbeitsmaschine nach einem der vorstehenden Ansprüche, wobei
- die Obermasse (1) eine Griffeinrichtung (13) aufweist, zum Führen der Arbeitsmaschine durch einen Benutzer; und wobei
- der Energiespeicher (10) und die Lüftereinrichtung (15) an der Griffeinrichtung (13) angeordnet sind.

6. Arbeitsmaschine nach einem der vorstehenden Ansprüche, wobei die Umformereinrichtung (11) an der Griffeinrichtung (13) angeordnet ist.

7. Arbeitsmaschine nach einem der vorstehenden Ansprüche, wobei
- an der Griffeinrichtung (13) eine Abdeckung (17) vorgesehen ist; und wobei
- der Energiespeicher (10) und/oder die Lüftereinrichtung (15) und/oder die Umformereinrichtung (11) unter der Abdeckung (17) angeordnet sind.

8. Arbeitsmaschine nach einem der vorstehenden Ansprüche, wobei die Arbeitsmaschine eine Bodenverdichtungsvorrichtung ist.

## Claims

1. Work machine comprising:
- a work device for effecting a work movement; and comprising
- a drive for driving the work device,
wherein
- the drive has an electric drive motor (5), an electric energy storage device (10) for supplying the drive motor (5) with an electric current, and a converter device (11) for converting the current from the energy storage device (10) and for supplying the current to the drive motor (5);
- a cooling apparatus is provided for cooling the energy storage device (10) and the converter device (11);
- the cooling apparatus has at least one fan device (15) for generating a cooling airflow (16) which can be guided via the energy storage device (10) and the converter device (11);
- the fan device (15) has a fan and a fan motor which drives the fan, **characterised in that**
- the fan motor is provided separately from the drive motor (5) of the drive; and wherein
- the fan is arranged in the cooling airflow (16) between the energy storage device (10) and the converter device (11).

2. Work machine as claimed in claim 1, wherein the cooling airflow (16) is guided between the energy storage device (10) and the converter device (11).

3. Work machine as claimed in any one of the preceding claims, wherein a fan control device is provided for activating the fan motor.

4. Work machine as claimed in any one of the preceding claims, wherein
- an upper mass (1) and a lower mass (2) are provided;
- the lower mass (2) is movable relative to the upper mass (1);
- the energy storage device (10), the converter device (11) and the cooling apparatus are arranged on the upper mass (1); and wherein
- a ground contact plate (4) for carrying out the work movement is provided on the lower mass (2).

5. Work machine as claimed in any one of the preceding claims, wherein
- the upper mass (1) has a handle device (13) for guiding the work machine by a user; and wherein
- the energy storage device (10) and the fan device (15) are arranged on the handle device (13).

6. Work machine as claimed in any one of the preceding claims, wherein the converter device (11) is arranged on the handle device (13).

7. Work machine as claimed in any one of the preceding claims, wherein
- a cover (17) is provided on the handle device (13); and wherein
- the energy storage device (10) and/or the fan device (15) and/or the converter device (11) are arranged under the cover (17).

8. Work machine as claimed in any one of the preceding claims, wherein the work machine is a ground compaction apparatus.

## Revendications

1. Machine de travail avec
- un dispositif de travail pour la réalisation d'un mouvement de travail ; et avec
- un dispositif d'entraînement pour l'entraînement du dispositif de travail ;
dans lequel
- le dispositif d'entraînement comprend un moteur d'entraînement électrique (5), un accumulateur d'énergie électrique (10) pour l'alimentation du moteur d'entraînement (5) en courant électrique et un dispositif de convertisseur (11) pour la conversion du courant provenant de l'accumulateur d'énergie (10) et l'introduction du courant dans le moteur d'entraînement (5) ;
- un dispositif de refroidissement est prévu, pour le refroidissement de l'accumulateur d'énergie (10) et du dispositif convertisseur (11) ;
- le dispositif de refroidissement comprend au moins un dispositif de ventilateur (15) pour la production d'un flux d'air de refroidissement (16), qui peut être guidé au-dessus de l'accumulateur d'énergie (10) et du dispositif de convertisseur (11) ;
- le dispositif de ventilateur (15) comprend un ventilateur et un moteur de ventilateur entraînant le ventilateur ; **caractérisé en ce que**
- le moteur du ventilateur est prévu séparément du moteur d'entraînement (5) du dispositif d'entraînement et dans laquelle
- le ventilateur est disposé dans le flux d'air de refroidissement (16) entre l'accumulateur d'énergie (10) et le dispositif de convertisseur (11).

2. Machine de travail selon la revendication 1, dans laquelle le flux d'air de refroidissement (16) est guidé entre l'accumulateur d'énergie (10) et le dispositif de convertisseur (11).

3. Machine de travail selon l'une des revendications précédentes, dans laquelle un dispositif de commande de ventilation est prévu, pour le contrôle du moteur du ventilateur.

4. Machine de travail selon l'une des revendications précédentes, dans laquelle
- une masse supérieure (1) et une masse inférieure (2) sont prévues ;
- la masse inférieure (2) est mobile par rapport à la masse supérieure (1) ;
- sur la masse supérieure (1) sont disposés l'accumulateur d'énergie (10), le dispositif de convertisseur (11) et le dispositif de refroidissement ; et dans laquelle
- sur la masse inférieure (2) est prévue une plaque de contact avec le sol (4), pour la réalisation du mouvement de travail.

5. Machine de travail selon l'une des revendications précédentes, dans laquelle
- la masse supérieure (1) comprend un dispositif de poignée (13) pour le guidage de la machine de travail par un utilisateur ; et dans laquelle
- l'accumulateur d'énergie (10) et le dispositif de ventilateur (15) sont disposés sur le dispositif de poignée (13).

6. Machine de travail selon l'une des revendications précédentes, dans laquelle le dispositif de convertisseur (11) est disposé sur le dispositif de poignée (13).

7. Machine de travail selon l'une des revendications précédentes, dans laquelle
- sur le dispositif de poignée (13), est prévu un couvercle (17) ; et dans laquelle
- l'accumulateur d'énergie (10) et/ou le dispositif de ventilateur (15) et/ou le dispositif de convertisseur (11) sont disposés sous le couvercle (17).

8. Machine de travail selon l'une des revendications précédentes, dans laquelle la machine de travail est un dispositif de compactage du sol.
